# FASCICULE DE BREVET EUROPEEN

(11) **EP 3 134 219 B1**
(45) Date de publication et mention de la délivrance du brevet: **02.10.2019**
(21) Numéro de dépôt: 15725754.4
(22) Date de dépôt: 17.04.2015
(51) Int. Cl.: B22C 9/04, B22C 9/22, B22D 27/04

(54) **MOULE POUR FONDERIE MONOCRISTALLINE**
FORM FÜR MONOKRISTALLINES GIESSEN
MOULD FOR MONOCRYSTALLINE CASTING

(30) Priorité: 24.04.2014 FR 1453693
(43) Date de publication de la demande: 01.03.2017
(73) Titulaire: SAFRAN AIRCRAFT ENGINES, 75015 Paris (FR)
(72) Inventeur: FARGEAS, Serge, 77550 Moissy-Cramayel Cedex (FR); COYEZ, Dominique, 77550 Moissy-Cramayel Cedex (FR)
(74) Mandataire: Calvo de Nó, Rodrigo
(86) Numéro de dépôt international: PCT/FR2015/051044
(87) Numéro de publication internationale: WO 2015/162362

(56) Documents cités:
- EP-A1- 1 452 251
- EP-A1- 1 894 647
- EP-A1- 2 092 999
- FR-A1- 2 734 189
- FR-A1- 2 995 807
- US-A- 4 940 073
- US-A- 5 404 930
- US-A1- 2009 078 390

## Description

### Arrière-plan de l'invention

La présente invention concerne le domaine de la fonderie, et plus particulièrement un modèle pour fonderie à modèle perdu, ainsi que des procédés de fabrication de moules carapaces et de fonderie utilisant un tel modèle.

Dans la description qui suit, les termes «haut», «bas», « horizontal » et « vertical » sont définis par l'orientation normale d'un tel moule lors de la coulée de métal dans son intérieur.

Des procédés de fonderie dits à cire perdue ou à modèle perdu sont connus depuis l'antiquité. Ils sont particulièrement adaptés pour la production de pièces métalliques avec des formes complexes. Ainsi, la fonderie à modèle perdu est notamment utilisée pour la production de pales de turbomachines.

Dans la fonderie à modèle perdu, la première étape est normalement la réalisation d'un modèle en matériau à température de fusion comparativement peu élevée, comme par exemple une cire ou résine. Ce modèle est lui-même enrobé de matériau réfractaire pour former un moule, et notamment un moule de type moule-carapace. Après évacuation ou élimination du matériau du modèle de l'intérieur du moule, ce qui donne son nom à ces procédés dits à modèle perdu, un métal en fusion est coulé dans ce moule, afin de remplir la cavité formée par le modèle dans le moule après son évacuation ou élimination. Une fois que le métal se refroidit et solidifie, le moule peut être ouvert ou détruit afin de récupérer une pièce métallique conforme à la forme du modèle. On entend par « métal », dans le présent contexte, tant des métaux purs que, surtout, des alliages métalliques.

Afin de pouvoir produire plusieurs pièces simultanément, il est possible de réunir plusieurs modèles dans une seule grappe dans laquelle ils sont reliés par un arbre formant, dans le moule, des canaux de coulée pour le métal en fusion.

Parmi les différents types de moules pouvant être utilisés dans la fonderie à modèle perdu, on connaît notamment les moules dits moules carapace, formés par trempage du modèle ou de la grappe de modèles dans une barbotine, suivi d'un saupoudrage du modèle ou de la grappe enduits de barbotine avec du sable réfractaire pour former une carapace autour du modèle ou de la grappe, et de la cuisson de cette carapace pour la fritter de manière à consolider l'ensemble. Plusieurs trempages et saupoudrages successifs peuvent être envisagés afin d'obtenir une carapace d'une épaisseur suffisante avant sa cuisson. On entend par « sable réfractaire », dans le présent contexte, tout matériau granulaire avec une granulométrie suffisamment fine pour satisfaire aux tolérances de production souhaitées, capable de résister, à l'état solide, aux températures du métal en fusion, et pouvant être consolidé d'un seul tenant lors de la cuisson de la carapace.

Afin d'obtenir des propriétés thermomécaniques particulièrement avantageuses dans une pièce produite par fonderie, il peut être souhaitable d'assurer une solidification dirigée du métal dans le moule. On entend par « solidification dirigée », dans le présent contexte, comme la maîtrise de la germination et croissance de cristaux solides dans le métal en fusion lors de son passage de l'état liquide à l'état solide. L'objet d'une telle solidification dirigée est celui d'éviter les effets négatifs des joints de grains dans la pièce. Ainsi, la solidification dirigée peut être colonnaire ou monocristalline. La solidification dirigée colonnaire consiste à orienter tous les joints de grains dans une même direction, de manière à ce qu'ils ne puissent pas contribuer à la propagation de fissures. La solidification dirigée monocristalline consiste à assurer la solidification de la pièce en un seul cristal, de manière à supprimer totalement les joints de grains.

Pour obtenir cette solidification dirigée monocristalline, le moule présente typiquement, sous la cavité de moulage, une cavité dite de démarrage reliée à la cavité de moulage par un canal sélecteur, comme divulgué par exemple dans le brevet français FR 2 734 189. Lors de la solidification du métal dans le moule, on opère un refroidissement progressif de celui-ci à partir de la cavité de démarrage, de manière à provoquer la germination des cristaux dans celle-ci. Le rôle du canal sélecteur est, d'une part, de privilégier un grain unique, et d'autre part, de permettre la progression de ce grain unique vers la cavité de moulage à partir du front de cristallisation de ce grain germé dans la cavité de démarrage.

Une forme étriquée de la cavité de moulage peut constituer un obstacle à cette solidification dirigée. Ainsi, dans une cavité de moulage présentant une saillie horizontale importante, comme notamment celle correspondant à une plateforme d'aube de turbomachine, le front de solidification peut brusquement cesser de progresser en direction sensiblement verticale pour progresser en direction de la saillie. Ce brusque changement de direction peut être à l'origine de défauts, et notamment de grains parasites, à proximité de cette saillie.

Afin d'éviter cela, la personne du métier peut faire appel à des conduits de grain, offrant au front de solidification des chemins alternatifs vers les saillies horizontales des cavités de moulage, et ceci sans changements brusques de direction. Toutefois, un inconvénient de ces conduits de grain est qu'ils compliquent le décochage du moule, et surtout que les branches métalliques résultantes de la solidification du matériau métallique dans le conduit de grain doivent ensuite être séparées de la pièce brute de fonderie, ajoutant des étapes de parachèvement compliquées et coûteuses. Un moule pour fonderie monocristalline du type général de la demande est aussi connu de US 2009/0078390 A1.

### Objet et résumé de l'invention

La présente divulgation vise à remédier à ces inconvénients en proposant un moule pour fonderie monocristalline pour le moulage de pièces présentant des saillies latérales importantes, qui facilite néanmoins le traitement ultérieur de la pièce brute de fonderie.

Dans au moins un mode de réalisation, ce but est atteint grâce au fait que ce moule, qui présente une cavité de moulage comprenant un premier volume, un deuxième volume, situé sur le premier volume, en communication avec celui-ci, et comprenant au moins une saillie horizontale par rapport au premier volume, et un conduit de grain avec une extrémité inférieure reliée au premier volume et une extrémité supérieure adjacente à ladite saillie horizontale du deuxième volume comprend en outre un organe de séparation interposé entre ledit deuxième volume de la cavité de moulage et l'extrémité supérieure du conduit de grain.

Grâce à ces dispositions, le refroidissement et donc la solidification du matériau métallique dans la cavité de moulage peut progresser à travers le conduit de grain vers la saillie horizontale, sans que le matériau métallique dans celle-ci soit directement en contact avec celui dans le conduit de grain, facilitant ainsi la séparation de la branche métallique formée par le conduit de grain du reste de la pièce brute de fonderie.

Afin d'assurer une progression constante du front de refroidissement dans la cavité de moulage, l'extrémité supérieure du conduit de grain peut présenter une largeur égale à ladite saillie horizontale du deuxième volume.

En particulier, un tel moule peut être utilisé dans la production d'aubes de turbomachine, et ceci tant pour des aubes fixes que pour des aubes ou pales mobiles. Pour cela, le premier volume de la cavité de moulage peut correspondre à un corps d'aube de turbomachine, et le deuxième volume de la cavité de moulage à une plateforme d'aube de turbomachine. On entend par « turbomachine », dans le présent contexte, toute machine dans laquelle peut s'opérer un transfert d'énergie entre un écoulement de fluide et au moins un aubage, comme, par exemple, un compresseur, une pompe, une turbine, ou bien une combinaison d'au moins deux de ceux-ci.

Afin de faciliter la solidification dirigée du matériau métallique en fusion dans la cavité de moulage, le moule peut présenter en outre, sous la cavité de moulage, une cavité de démarrage reliée à la cavité de moulage par un canal sélecteur.

La présente divulgation concerne également un procédé de fabrication d'un tel moule pour fonderie monocristalline, comprenant les étapes de réalisation d'un modèle reproduisant la forme de la cavité de moulage, enrobage dudit modèle avec un matériau réfractaire de manière à conformer la cavité de moulage, et évacuation de la cavité de moulage.

En particulier, pour faciliter l'intégration de l'organe de séparation dans le moule, ledit organe de séparation peut être inséré dans le modèle avant l'étape d'enrobage. Le modèle peut notamment être en matériau fusible à température inférieure audit matériau réfractaire, comme par exemple une cire ou résine, et être évacué de la cavité de moulage à l'état liquide, suivant le procédé dit de « cire perdue ».

Ladite étape d'enrobage peut notamment être mise en oeuvre en trempant le modèle dans une barbotine, saupoudrant le modèle avec un sable réfractaire afin de former une carapace autour du modèle, et frittant cette carapace afin de la consolider, formant ainsi une moule-carapace.

La présente divulgation concerne également un procédé d'utilisation d'un tel moule, comprenant la coulée sous vide d'un matériau métallique à l'état liquide dans la cavité de moulage, la solidification dirigée du matériau métallique du bas de la cavité de moulage vers le haut, et le décochage du moule, y compris de l'organe de séparation interposé entre le deuxième volume de la cavité de moulage et l'extrémité supérieure du conduit de grain. Dans le présent contexte, l'expression « sous vide » doit être interprétée comme signifiant à une pression sensiblement inférieure à la pression atmosphérique, et en particulier inférieure à 0,1 à 0,01 Pa. Suite au décochage du moule, la pièce brute de fonderie formée par le matériau métallique solidifié à l'intérieur de la cavité de moulage peut faire l'objet de traitements supplémentaires, notamment pour séparer la branche de matériau métallique solidifiée dans le conduit de grain.

### Brève description des dessins

L'invention sera bien comprise et ses avantages apparaîtront mieux, à la lecture de la description détaillée qui suit, d'un mode de réalisation représenté à titre d'exemple non limitatif. La description se réfère aux dessins annexés sur lesquels :
- la figure 1 est une représentation schématique d'une installation pour fonderie monocristalline avec un moule suivant un mode de réalisation ;
- la figure 2 est une vue schématique en perspective d'un modèle pour la production du moule de la figure 1 ; et
- les figures 3, 4 et 5 illustrent schématiquement la progression d'un front de refroidissement et solidification dans un procédé de fonderie dans l'installation de la figure 1.

### Description détaillée de l'invention

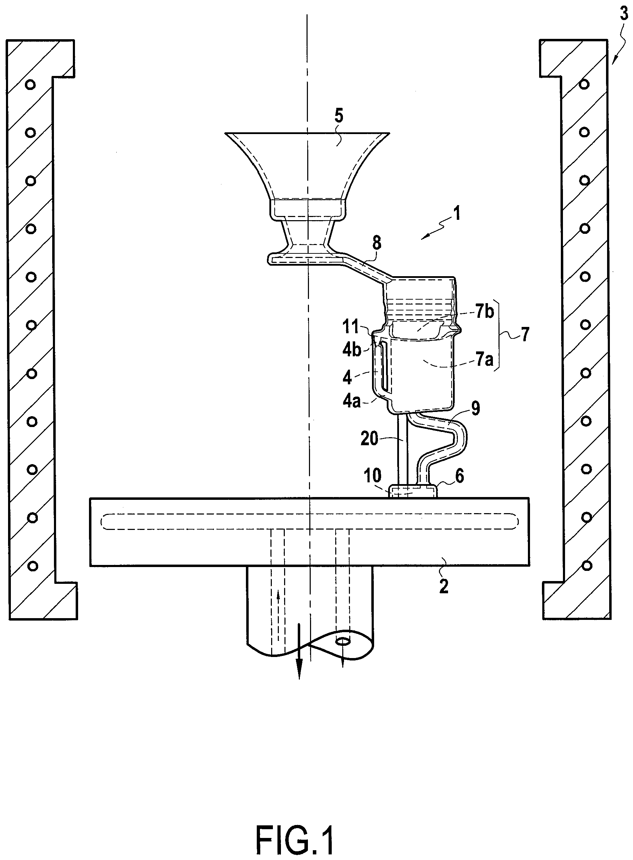

La figure 1 illustre comment un refroidissement progressif du métal en fusion destiné à obtenir une solidification dirigée peut typiquement être réalisé dans un procédé de fonderie.

Le moule 1 utilisé dans ce procédé comporte un godet de coulée 5 et une base 6. Pendant l'extraction du moule 1 de la chambre de chauffage 3, cette base 6 va être directement en contact avec une sole 2. Le moule 1 comprend aussi une cavité de moulage 7. Il est également possible d'arranger plusieurs cavités de moulage en grappe dans un même moule. La cavité de moulage 7 est reliée au godet de coulée 5 par un canal d'amenée 8 au travers duquel le métal en fusion est introduit lors de sa coulée. La cavité de moulage 7 est aussi également reliée par le bas, à travers un canal sélecteur 9 en chicane, à une plus petite cavité de démarrage 10 dans la base 6. Dans le mode de réalisation illustré, la cavité de moulage 7 comprend un premier volume 7a et un deuxième volume 7b, situé directement sur le premier volume 7a, en communication avec celui-ci, et sensiblement plus large dans un plan horizontal, de telle manière qu'il présente au moins une saillie horizontale très sensible par rapport au premier volume 7a. Plus spécifiquement, dans le mode de réalisation illustré, le moule 1 est destiné à la production d'aubes de turbomachine. En conséquence, le premier volume 7a correspond à un corps d'aube et le deuxième volume 7b à une plateforme d'aube.

La cavité de moulage 7 comprend aussi un conduit de grain 4 avec une extrémité inférieure 4a reliée directement au premier volume 7a et une extrémité supérieure 4b adjacente à la saillie horizontale du deuxième volume 7b. Dans le mode de réalisation illustré, ladite extrémité supérieure 4b est élargie par rapport au reste du conduit de grain 4, de manière à être adjacente à ladite saillie horizontale du deuxième volume 7b sur toute la largeur L de ce deuxième volume 7b. Bien qu'adjacents, la extrémité supérieure 4b du conduit de grain 4 et ledit deuxième volume 7b ne sont pas en communication directe, puisque séparés par un organe de séparation 11 en forme de tige.

Cet organe de séparation 11 peut être, par exemple, en matériau céramique. Bien que dans le mode de réalisation illustré il prend la forme d'une tige cylindrique à section transversale circulaire, d'autres sections transversales et d'autres formes en général peuvent être alternativement adoptées selon les circonstances. Les dimensions et conductivité thermique du matériau de la tige peuvent être choisies afin d'offrir un bon contact thermique entre la extrémité supérieure 4b du conduit de grain 4 et la saillie horizontale adjacente du deuxième volume 7b de la cavité de moulage 7.

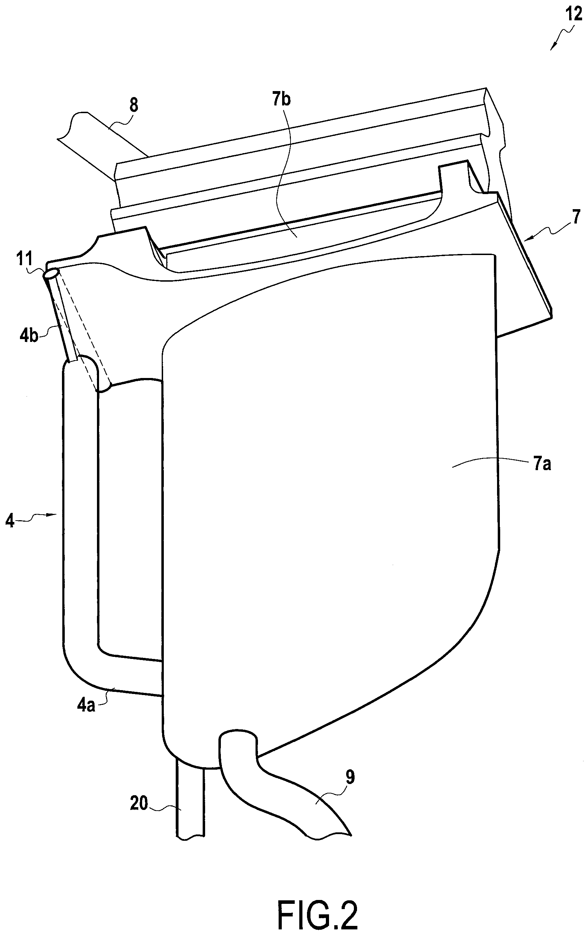

Le moule 1 peut être produit par le procédé dit à cire perdue ou à modèle perdu. Une première étape d'un tel procédé est la création d'un modèle 12, comme celui illustré sur la figure 2. Le modèle 12 est destiné à former la cavité de moulage 7, ainsi que la cavité de démarrage 10, le canal sélecteur 9, le godet de coulée 5 et le canal d'amenée 8, en creux dans le moule 1. Ce modèle est obtenu à partir d'une matière à basse température de fusion, comme une cire ou résine appropriées. Lorsque la production de grands nombres de pièces est envisagée, il est notamment possible de produire ces éléments par injection de la cire ou résine dans un moule permanent. Afin de soutenir le modèle 12, une tige de soutien 20 en matériau réfractaire, par exemple céramique, est intégrée dans le modèle 12, reliant son corps principal 7', correspondant à la cavité de moulage 7, à sa base (non illustrée), correspondant à la cavité de démarrage 10. Afin de rendre cette tige de soutien 20 solidaire du modèle 12, on peut utiliser l'adhérence naturelle du matériau du modèle 12, ou utiliser un adhésif adapté. L'organe de séparation 11 peut aussi être intégré de la même manière dans le modèle 12, entre les volumes du corps principal 7' correspondant à l'extrémité supérieure 4b du conduit de grain 4 et à la saillie horizontale adjacente du deuxième volume 7b de la cavité de moulage 7.

Dans ce mode de réalisation, pour produire le moule 1 à partir de ce modèle non-permanent 12, on procède à tremper le modèle 12 dans une barbotine, pour ensuite le saupoudrer avec un sable réfractaire. Ces étapes de trempage et saupoudrage peuvent être répétées plusieurs fois, jusqu'à former une carapace de sable imprégné de barbotine d'une épaisseur souhaitée autour du modèle 12.

Le modèle 12 enrobé de cette carapace peut ensuite être chauffé pour faire fondre et évacuer de l'intérieur de la carapace la matière à basse température de fusion du modèle 12, tout en conservant la tige de soutien 20 et l'organe de séparation 11. Ensuite, dans une étape de cuisson à plus haute température, la carapace est frittée de manière à consolider le sable réfractaire pour former le moule 1, dans lequel la tige de soutien 20 et l'organe de séparation 11 restent intégrés.

Le métal ou alliage métallique utilisé dans ce procédé de fonderie est coulé en fusion dans le moule 1, à travers le godet de coulée 5, et remplit la cavité de démarrage 10, le canal sélecteur 9 et la cavité de moulage 7 à travers le canal d'amenée 8. Parmi les alliages métalliques pouvant être utilisés dans ce procédé, on compte notamment les alliages monocristallins de nickel, tels que, notamment, les AM1 et AM3 de SNECMA, mais aussi d'autres comme les CMSX-2®, CMSX-4®, CMSX-6 ®, et CMSX-10 ® du C-M Group, les René® N5 et N6 de General Electric, les RR2000 et SRR99 de Rolls-Royce, et les PWA 1480, 1484 et 1487 de Pratt & Whitney, entre autres. Le tableau 1 illustre les compositions de ces alliages :

**Tableau 1 : Compositions d'alliages de nickel monocristallins en % massique**

| Alliage | Cr | Co | Mo | W | Al | Ti | Ta | Nb | Re | Hf | C | B | Ni |
|---|---|---|---|---|---|---|---|---|---|---|---|---|---|
| CMSX-2 | 8,0 | 5,0 | 0,6 | 8,0 | 5,6 | 1,0 | 6,0 | - | - | - | - | - | Bal |
| CMSX-4 | 6,5 | 9,6 | 0,6 | 6,4 | 5,6 | 1,0 | 6,5 | - | 3,0 | 0,1 | - | - | Bal |
| CMSX-6 | 10,0 | 5,0 | 3,0 | - | 4,8 | 4,7 | 6,0 | - | - | 0,1 | - | - | Bal |
| CMSX-10 | 2,0 | 3,0 | 0,4 | 5,0 | 5,7 | 0,2 | 8,0 | - | 6,0 | 0,03 | - | - | Bal |
| René N5 | 7,0 | 8,0 | 2,0 | 5,0 | 6,2 | - | 7,0 | - | 3,0 | 0,2 | - | - | Bal |
| René N6 | 4,2 | 12,5 | 1,4 | 6,0 | 5,75 | - | 7,2 | - | 5,4 | 0,15 | 0,05 | 0,004 | Bal |
| RR2000 | 10,0 | 15,0 | 3,0 | - | 5,5 | 4,0 | - | - | - | - | - | - | Bal |
| SRR99 | 8,0 | 5,0 | - | 10,0 | 5,5 | 2,2 | 12,0 | - | - | - | - | - | Bal |
| PWA1480 | 10,0 | 5,0 | - | 4,0 | 5,0 | 1,5 | 12,0 | - | - | - | 0,07 | - | Bal |
| PWA1484 | 5,0 | 10,0 | 2,0 | 6,0 | 5,6 | - | 9,0 | - | 3,0 | 0,1 | - | - | Bal |
| PWA1487 | 5,0 | 10,0 | 1,9 | 5,9 | 5,6 | - | 8,4 | - | 3,0 | 0,25 | - | - | Bal |
| AM1 | 7,0 | 8,0 | 2,0 | 5,0 | 5,0 | 1,8 | 8,0 | 1,0 | - | - | - | - | Bal |
| AM3 | 8,0 | 5,5 | 2,25 | 5,0 | 6,0 | 2,0 | 3,5 | - | - | - | - | - | Bal |

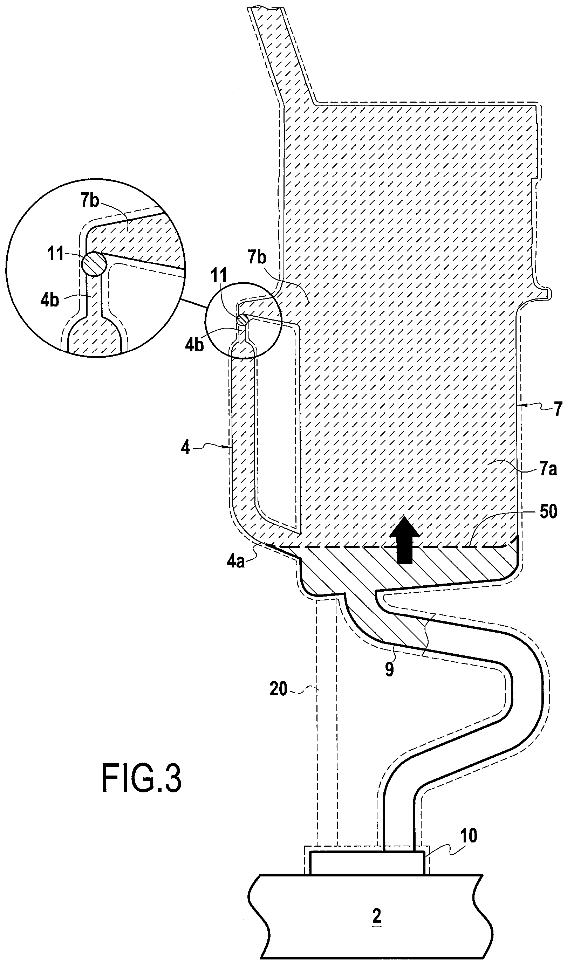

Pendant la coulée, le moule 1 est maintenu dans une chambre de chauffage 3, comme illustré sur la figure 1. Ensuite, afin d'obtenir le refroidissement progressif du métal en fusion, ce moule 1, soutenu par un support 2 refroidi et mobile, est extrait de la chambre de chauffage 3, suivant un axe principal X, vers le bas. Le moule 1 étant refroidi à travers sa base 6 par le support 2, la solidification du métal en fusion va se déclencher dans la cavité de démarrage 10 et se propager en direction sensiblement verticale vers le haut du moule 1 suite à son extraction progressive de la chambre de chauffage 3 par le bas, suivant un front 50 comme illustré sur la figure 3. L'étranglement formé par le canal sélecteur 9, ainsi que sa forme en chicane, vont toutefois assurer qu'un seul grain, parmi ceux ayant initialement germé dans la cavité de démarrage 10, va pouvoir continuer à s'étendre vers la cavité de moulage 7.

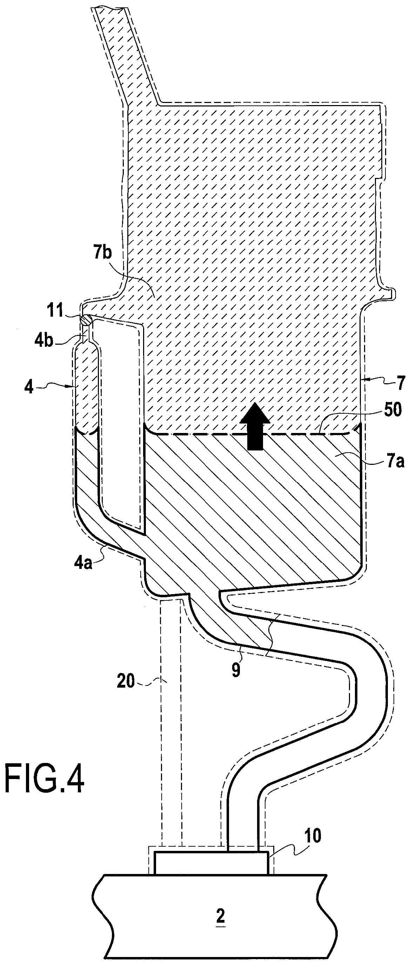

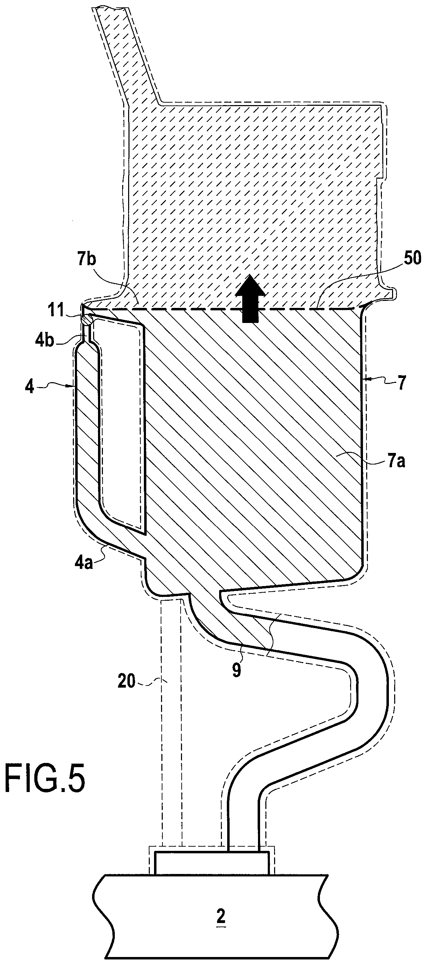

Au niveau de l'extrémité inférieure 4a du conduit de grain 4, le front 50 de refroidissement et solidification du métal va bifurquer, continuant sa progression sur le premier volume 7a de la cavité de moulage 7, d'une part, et d'autre part sur le conduit de grain 4, comme illustré sur la figure 4. En conséquence, ce front 50 de refroidissement et solidification va approcher sensiblement en même temps l'interface entre les premier et deuxième volumes 7a, 7b de la cavité de moulage 7, et l'extrémité supérieure 4b du conduit de grain 4. Ainsi, grâce à la conduction thermique entre cette extrémité supérieure 4b du conduit de grain 4 et la saillie horizontale du deuxième volume de la cavité de moulage 7, le front 50 de refroidissement et solidification peut maintenir, dans le deuxième volume 7b, une direction de progression sensiblement verticale, illustrée sur la figure 5, comme si l'extrémité supérieure 4b du conduit de grain 4 communiquait effectivement avec la saillie horizontale du deuxième volume de la cavité de moulage 7. On évite ainsi un changement brusque de direction de cette progression dans le deuxième volume 7b, pouvant générer des grains parasites autour de l'interface entre les volumes 7a et 7b de la cavité de moulage 7.

Après le refroidissement et la solidification du métal dans le moule 1, celui-ci pourra être décoché pour libérer la pièce métallique, laquelle pourra ensuite être finie par des procédés d'usinage et/ou des traitements de surface. Le décochage du moule et le traitement de finition de la pièce sont très sensiblement facilités par la séparation entre l'extrémité supérieure 4a du conduit de grain 4 et le deuxième volume 7b de la cavité de moulage 7, puisqu'il suffira de rompre une seule connexion entre la pièce métallique et la branche métallique correspondant au conduit de grain pour les séparer.

Quoique la présente invention ait été décrite en se référant à un exemple de réalisation spécifique, il est évident que des différentes modifications et changements peuvent être effectués sur ces exemples sans sortir de la portée générale de l'invention telle que définie par les revendications. En outre, des caractéristiques individuelles des différents modes de réalisation évoqués peuvent être combinées dans des modes de réalisation additionnels. Par conséquent, la description et les dessins doivent être considérés dans un sens illustratif plutôt que restrictif.

## Revendications

1. Moule (1) pour fonderie monocristalline présentant :
une cavité de moulage (7) comprenant :
un premier volume (7a) ;
un deuxième volume (7b), situé sur le premier volume (7a), en communication avec celui-ci, et comprenant au moins une saillie horizontale par rapport au premier volume (7a) ; et
un conduit de grain (4) avec une extrémité inférieure (4a) reliée au premier volume (7a) et une extrémité supérieure (4b) adjacente à ladite saillie horizontale du deuxième volume (7b) ;
ledit moule (1) étant **caractérisé en ce qu'**il comprend un organe de séparation (11) interposé entre ledit deuxième volume (7b) de la cavité de moulage (7) et l'extrémité supérieure (4b) du conduit de grain (4).

2. Moule (1) suivant la revendication 1, dans lequel l'extrémité supérieure (4b) du conduit de grain (4) présente une largeur égale à ladite saillie horizontale du deuxième volume (7b).

3. Moule (1) suivant l'une quelconque des revendications précédentes, dans lequel le premier volume (7a) de la cavité de moulage (7) correspond à un corps d'aube de turbomachine, et le deuxième volume (7b) de la cavité de moulage (7) correspond à une plateforme d'aube de turbomachine.

4. Moule (1) suivant l'une quelconque des revendications précédentes, présentant aussi, sous la cavité de moulage (7), une cavité de démarrage (10) reliée à la cavité de moulage (7) par un canal sélecteur (9).

5. Procédé de fabrication d'un moule (1) pour fonderie monocristalline suivant l'une quelconque des revendications 1 à 4, comprenant les étapes suivantes :
réalisation d'un modèle (12) reproduisant au moins la forme de la cavité de moulage (7) ;
enrobage dudit modèle (12) avec un matériau réfractaire de manière à conformer au moins la cavité de moulage (7) ; et
évacuation d'au moins la cavité de moulage (7).

6. Procédé suivant la revendication 5, dans lequel ledit organe de séparation (11) est inséré dans ledit modèle (12) avant l'étape d'enrobage.

7. Procédé suivant l'une quelconque des revendications 5 ou 6, dans lequel ledit modèle (12) est en matériau fusible à température inférieure audit matériau réfractaire et est évacué de la cavité de moulage (7) à l'état liquide.

8. Procédé suivant l'une quelconque des revendications 5 à 7, dans lequel ladite étape d'enrobage est mise en oeuvre en trempant le modèle (12) dans une barbotine, saupoudrant le modèle avec un sable réfractaire afin de former une carapace autour du modèle (12), et frittant cette carapace afin de la consolider.

9. Utilisation d'un moule (1) pour fonderie monocristalline suivant l'une quelconque des revendications 1 à 4, comprenant les étapes suivantes :
coulée sous vide d'un matériau métallique à l'état liquide dans la cavité de moulage (7) ;
solidification dirigée du matériau métallique du bas de la cavité de moulage (7) vers le haut ; et
décochage du moule (1), y compris de l'organe de séparation (11) interposé entre le deuxième volume (7b) de la cavité de moulage et l'extrémité supérieure (4b) du conduit de grain (4).

## Patentansprüche

1. Form (1) für monokristallines Gießen, aufweisend:
einen Formhohlraum (7), umfassend:
ein erstes Volumen (7a),
ein zweites Volumen (7b), das über dem ersten Volumen (7a) in Verbindung mit diesem angeordnet ist und wenigstens einen horizontalen Vorsprung in Bezug auf das erste Volumen (7a) aufweist, und
eine Kornleitung (4) mit einem unteren Ende (4a), das mit dem ersten Volumen (7a) verbunden ist, und einem oberen Ende (4b), das an den horizontalen Vorsprung des zweiten Volumens (7b) angrenzt,
wobei die Form (1) **dadurch gekennzeichnet ist, dass** sie ein Trennorgan (11) umfasst, das zwischen dem zweiten Volumen (7b) des Formhohlraums (7) und dem oberen Ende (4b) der Kornleitung (4) angeordnet ist.

2. Form (1) nach Anspruch 1, bei der das obere Ende (4b) der Kornleitung (4) eine Breite aufweist, die gleich dem horizontalen Vorsprung des zweiten Volumens (7b) ist.

3. Form (1) nach einem der vorhergehenden Ansprüche, bei der das erste Volumen (7a) des Formhohlraums (7) einem Körper einer Turbomaschinenschaufel entspricht und das zweite Volumen (7b) des Formhohlraums (7) einer Plattform einer Turbomaschinenschaufel entspricht.

4. Form (1) nach einem der vorhergehenden Ansprüche, die unter dem Formhohlraum (7) auch einen Starthohlraum (10) aufweist, der durch einen Auswahlkanal (9) mit dem Formhohlraum (7) verbunden ist.

5. Verfahren zur Herstellung einer Form (1) für monokristallines Gießen nach einem der Ansprüche 1 bis 4, das die folgenden Schritte umfasst:
Herstellen eines Modells (12), das wenigstens die Form des Formhohlraums (7) wiedergibt,
Ummanteln des Modells (12) mit einem feuerfesten Material, um wenigstens den Formhohlraum (7) zu gestalten, und
Entleeren wenigstens des Formhohlraums (7).

6. Verfahren nach Anspruch 5, bei dem das Trennorgan (11) vor dem Schritt des Ummantelns in das Modell (12) eingefügt wird.

7. Verfahren nach einem der Ansprüche 5 oder 6, bei dem das Modell (12) aus einem Material besteht, das bei einer niedrigeren Temperatur als das feuerfeste Material schmelzbar ist, und im flüssigen Zustand aus dem Formhohlraum (7) abgeführt wird.

8. Verfahren nach einem der Ansprüche 5 bis 7, bei dem der Schritt des Ummantelns dadurch vollzogen wird, dass das Modell (12) in einen Schlicker eingetaucht wird, das Modell mit einem feuerfesten Sand bestreut wird, um eine Schale um das Modell (12) herum zu bilden, und diese Schale gesintert wird, um sie zu verfestigen.

9. Verwendung einer Form (1) für monokristallines Gießen nach einem der Ansprüche 1 bis 4, die die folgenden Schritte umfasst:
Vakuumgießen eines metallischen Materials in flüssigem Zustand in den Formhohlraum (7),
gerichtetes Verfestigen des metallischen Materials von der Unterseite des Formhohlraums (7) nach oben, und
Auspacken der Form (1), einschließlich des Trennorgans (11), das zwischen dem zweiten Volumen (7b) des Formhohlraums und dem oberen Ende (4b) der Kornleitung (4) angeordnet ist.

## Claims

1. A monocrystalline casting mold (1) presenting:
• a mold cavity (7) comprising:
• a first volume (7a);
• a second volume (7b) situated on the first volume (7a), in communication therewith, and having at least one horizontal projection relative to the first volume (7a); and
• a grain duct (4) with a bottom end (4a) connected to the first volume (7a) and a top end (4b) adjacent to said horizontal projection of the second volume (7b);
said mold (1) being **characterized in that** it includes a separator member (11) interposed between said second volume (7b) of the mold cavity (7) and the top end (4b) of the grain duct (4).

2. A mold (1) according to claim 1, wherein the top end (4b) of the grain duct (4) presents a width that is substantially equal to said horizontal projection of the second volume (7b).

3. A mold (1) according to any preceding claim, wherein the first volume (7a) of the mold cavity (7) corresponds to a turbomachine blade body and the second volume (7b) of the mold cavity (7) corresponds to a turbomachine blade platform.

4. A mold (1) according to any preceding claim, also presenting, under the mold cavity (7), a starter cavity (10) connected to the mold cavity (7) by a selector channel (9).

5. A method of fabricating a monocrystalline casting mold (1) according to any one of claims 1 to 4, the method comprising the following steps:
• making a model (12) reproducing at least the shape of the mold cavity (7);
• coating said model (12) in a refractory material so as to form at least the mold cavity (7); and
• emptying out at least the mold cavity (7).

6. A method according to claim 5, wherein said separator member (11) is inserted in said model (12) before the coating step.

7. A method according to claim 5 or claim 6, wherein said model (12) is made of a material that melts at a temperature lower than said refractory material and is emptied out from the mold cavity (7) in the liquid state.

8. A method according to any one of claims 5 to 7, wherein said coating step is performed by dipping the model (12) in a slip, dusting the model with a refractory sand in order to form a shell around the model (12), and sintering the shell in order to consolidate it.

9. The use of a mold (1) for monocrystalline casting according to any one of claims 1 to 4, the use comprising the following steps:
• vacuum casting a metal material in the liquid state into the mold cavity (7);
• causing the metal material to solidify in directional manner from the bottom of the mold cavity (7) towards the top; and
• knocking out the mold (1), including the separator member (11) interposed between the second volume (7b) of the mold cavity and the top end (4b) of the grain duct (4) .
